# EUROPEAN PATENT SPECIFICATION

(11) **EP 2 763 520 B1**
(45) Date of publication and mention of the grant of the patent: **20.12.2017**
(21) Application number: 13190873.3
(22) Date of filing: 30.10.2013
(51) Int. Cl.: H05K 9/00

(54) **Electrically conductive porous material assemblies and methods of making the same**
Elektrisch leitende poröse Materialanordnungen und Herstellungsverfahren dafür
Ensembles de matériau poreux conducteur d'électricité et procédés de fabrication associés

(30) Priority: 31.01.2013 WO PCT/CN2013/071196; 01.07.2013 CN 201310271981
(43) Date of publication of application: 06.08.2014
(73) Proprietor: Laird Technologies, Inc., Earth City, MO 63045 (US)
(72) Inventor: Creasy, Larry D. Jr., St. Clair, MO 63077 (US); Tsai, Richard, Xinbei City (TW); Ou, Baoquan, Shenzhen City (CN); Wood, David B., St. Louis, MO 63112 (US)
(74) Representative: Awapatent AB

(56) References cited:
- WO-A1-00/10802
- WO-A1-93/05960
- US-A- 4 720 400
- US-A1- 2007 095 567
- US-A1- 2010 300 744
- US-B2- 7 060 348

## Description

### CROSS-REFERENCE TO RELATED APPLICATIONS

This application claims the benefit and priority of Chinese patent application number 201310271981.9 filed July 1, 2013. This application is a continuation-in-part of International Patent Application No. PCT/CN2013/071196 filed January 31, 2013. The entire disclosures of the above applications are incorporated herein by reference.

### FIELD

The present disclosure relates to electrically conductive porous material assemblies and methods of making or producing the same.

### BACKGROUND

This section provides background information related to the present disclosure which is not necessarily prior art.

A common problem in the operation of electronic devices is the generation of electromagnetic radiation within the electronic circuitry of the equipment. Such radiation results in "electromagnetic interference" or "EMI", which can interfere with the operation of other electronic devices within a certain proximity.

A common solution to ameliorate the effects of EMI has been the development of shielding materials capable of absorbing and/or reflecting EMI energy. These shielding materials are employed to localize EMI within its source, and to insulate other devices proximal to the EMI source.

Moreover, an objective for all EMI shielding materials to be used in electronic devices is that they must not only comply with FCC requirements, but EMI shielding materials should also meet Underwriter's Laboratories (UL) standards for flame retardancy. In this context, EMI shielding materials should ideally be made flame retardant in a manner that does not compromise the shielding properties necessary for meeting EMI shielding requirements.

Electromagnetic interference shielding vent panels including electrically-conductive porous substrates and meshes connected by an electrically-conductive adhesive are disclosed in US 2007/095567 (A1). This document considers the use of different materials like copper, nickel and palladium for plating the porous substrate to make it conductive. Also the porous substrate may be impregnated with flame retardant to reach the desired flame rating.

### SUMMARY

This section provides a general summary of the disclosure, and is not a comprehensive disclosure of its full scope or all of its features.

According to various aspects, exemplary embodiments are disclosed of electrically conductive porous material assemblies. Also disclosed are exemplary methods of making or producing electrically conductive porous material assemblies. In an exemplary embodiment, an electrically conductive porous material assembly generally includes an electrically conductive porous material and a first layer of electrically conductive porous fabric. A first layer of adhesive is between the first layer of electrically conductive porous fabric and the electrically conductive porous material.

In other exemplary embodiments, there are methods of making an electrically conductive porous material assembly. In an exemplary embodiment, a method generally includes adhesively attaching a first layer of electrically conductive porous fabric to a first side of an electrically conductive porous material.

Further areas of applicability will become apparent from the description provided herein. The description and specific examples in this summary are intended for purposes of illustration only and are not intended to limit the scope of the present disclosure.

### DRAWINGS

The drawings described herein are for illustrative purposes only of selected embodiments and not all possible implementations, and are not intended to limit the scope of the present disclosure

FIGS. 1 through 5 show exemplary embodiments of electrically conductive flame retardant porous material assemblies and exemplary processes for making the same;

FIG. 6 is a line graph of shielding effectiveness in decibels (dB) versus frequency in hertz (Hz) measured for a test specimen of electrically conductive flame retardant porous material assembly according to an exemplary embodiment; and

FIGS. 7 through 9 are force displacement resistance line graphs showing Z-axis resistance (in ohms per square inch) and force (pounds per square inch) versus percentage compression measured for various test specimens of electrically conductive flame retardant porous material assemblies according to exemplary embodiments.

### DETAILED DESCRIPTION

Example embodiments will now be described more fully with reference to the accompanying drawings.

The inventors hereof have recognized the need for and have developed methods of making electrically conductive porous material assemblies without having to use silver, *e.g.,* without silver plating, at the location where the method is performed. By way of comparison, an existing method includes plating silver onto the internal surfaces of the pores or internal interstices of a foam. But the inventors hereof have recognized that silver plating is not permitted in all regions, such as in a certain part or area of Shenzhen, China. Accordingly, the inventors have developed and disclose herein exemplary embodiments of electrically conductive porous material assemblies and methods of making or producing the same without having to use silver, *e.g.,* without silver plating, at the location where the method is performed. In some exemplary embodiments, the electrically conductive porous material assemblies function and perform comparable to the aforementioned electrically conductive silver plated foam.

As disclosed herein, exemplary embodiments of the electrically conductive porous material assemblies may be flame retardant (*e.g.,* UL-94 V-0, *etc.),* exhibit Z-axis conductivity, Z-axis resistance, or bulk resistivity suitable for electromagnetic shielding applications, and halogen free (*e.g.,* no more than a maximum of 900 parts per million chlorine, no more than a maximum of 900 parts per million bromine, and no more than a maximum of 1,500 parts per million total halogens, *etc.).* Such exemplary embodiments may also be referred to herein as halogen free, flame retardant, electrically conductive EMI shielding materials.

In exemplary embodiments, a method of producing or making an electrically conductive porous material assembly includes applying plated mesh *(e.g.,* metalized fabric from Laird Technologies, Inc., *etc.)* to plated foam *(e.g.,* polyurethane open-cell foam plated with metal, *etc.)* using an adhesive *(e.g.,* light weight, hot melt web adhesive, *etc.)* to maintain Z-axis contact and then laminating the plated mesh to the electrically conductive foam. The laminated composite or stack of materials is then coated with flame retardant (*e.g.,* halogen free flame retardant, *etc*.) such that the end product has a flame rating (*e.g.,* UL V-0, *etc*.).

In one example, plated mesh is adhesively attached to plated foam along both of the upper and lower sides of the plated foam. This example electrically conductive porous material assembly or end product has Z-axis conductivity from top to bottom through the five layers of material. The five layers are the top and bottom layers of plated mesh, the plated foam, and upper and lower layers of adhesive between the plated foam and respective top and bottom plated mesh layers.

In another example, plated mesh is adhesively attached along only one side of the plated foam. This example electrically conductive porous material assembly or end product has Z-axis conductivity from top to bottom through the three layers of material. In this example, the three layers are the layer of plated mesh, the plated foam, and the layer of adhesive between the plated foam and plated mesh layer.

Exemplary embodiments include adhesive (*e.g.,* web adhesive, *etc.)* that allows the one or more layers of electrically conductive porous fabric *(e.g.,* plated mesh, *etc.)* to contact the electrically conductive porous material *(e.g.,* plated foam, *etc.)* and keep electrical flow from top to bottom while also still holding the layers *(e.g.,* plated mesh and foam layers, *etc.)* together. These exemplary embodiments thus have good Z-axis conductivity with and without a flame retardant treatment or coating as disclosed herein. By way of further example, an exemplary embodiment of an electrically conductive porous material assembly includes top and bottom layers of plated mesh along or on opposite top and bottom sides of plated foam. A first or upper layer of web adhesive is between the top plated mesh layer and top side of the plated foam. A second or lower layer of web adhesive is between the bottom plated mesh layer and the bottom side of the plated foam. In this example, the web adhesive layers allows the plated mesh layers to contact the plated foam and keep electrical flow from top to bottom while also still holding the mesh and foam layers together. This exemplary embodiment has good Z-axis conductivity with and without a flame retardant treatment or coating.

Another exemplary embodiment of an electrically conductive porous material assembly includes only one layer of plated mesh along or on either the top or bottom side of plated foam. A layer of web adhesive is between the plated mesh layer and the plated foam. In this example, the web adhesive layer allows the plated mesh layer to contact the plated foam and keep electrical flow from top to bottom while also still holding the mesh and foam layers together. This exemplary embodiment has good Z-axis conductivity with and without a flame retardant treatment or coating.

In example methods, silver is not used at the location where the method is performed, *e.g.,* foam is not plated with silver at the location. This, in turn, allows this method or process to be performed in a region that does not allow silver plating. Also in this example, the foam core (or other porous core material) and outer mesh (or other porous fabric) are plated in separate steps and thereafter joined together after plating by using a light weight, hot melt web adhesive and a lamination process, *e.g.,* using a Meyer flatbed laminator, *etc.* In some embodiments, the electrically conductive foam and plated mesh may be obtained from an outside source after it has already been plated in a different geographic location. In which case, the method does not include the steps of plating the foam and plating the mesh. But the method may instead include selecting or obtaining foam and mesh that are already plated. In other exemplary embodiments, the method may include plating dielectric foam and/or plating dielectric mesh before adhesively attaching the mesh to the opposite sides of the foam.

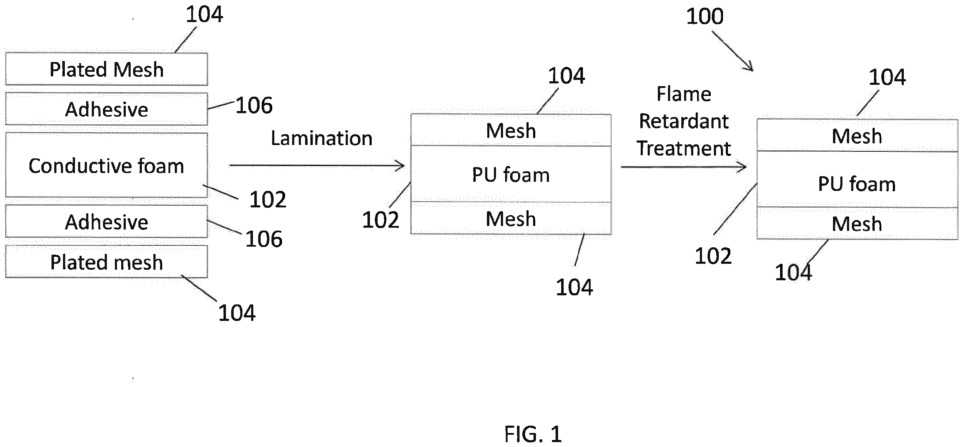

With reference now to the figures, FIG. 1 shows a first exemplary embodiment of an electrically conductive porous material assembly (or laminated stack of materials) 100 and exemplary method of making or producing the same, which embody one or more aspects of the present disclosure. As shown, the electrically conductive porous material assembly 100 includes an electrically conductive foam 102 (broadly, an electrically conductive porous material). A plated mesh 104 (broadly, an electrically conductive porous fabric) is on or along opposite sides of the foam 102.

As shown in FIG. 1, adhesive 106 and a lamination process are used for attaching the plated mesh 104 to opposite first and second sides of the electrically conductive foam 102. More specifically, a first layer of adhesive 106 is between a first layer of plated mesh 104 and a first or upper side of the electrically conductive foam 102. A second layer of adhesive 106 is between a second layer of plated mesh 104 and a second or lower side of the electrically conductive foam 102.

In this example, the electrically conductive porous material assembly 100 also undergoes a flame retardant treatment as disclosed herein. By way of example only, the flame retardant treatment in this example method may be similar or identical to a flame retardant coating process described in U.S. Patent 7,060,348 by which the electrically conductive foam is UL V-0 and halogen free. The entire disclosure of U.S. Patent 7,060,348 is incorporated herein by reference.

With continued reference to FIG. 1, example operational parameters for laminating and flame retardant treatment will be now provided for purposes of illustration only. Alternative embodiments may include different operational parameters (*e.g.,* higher or lower temperature ranges, *etc.).*

A first step, process, or operation includes laminating a first one of the two layers of plated mesh 104 to the electrically conductive foam 102. In this example, the laminating is performed using a flatbed laminator at a temperature within a range from about 140°C to about 160°C, a speed within a range from about 3 meters per minute to about 6 meters per minute, and with gaps between the belts or rollers within a range from about 1 millimeter to about 5 millimeters.

A second step, process, or operation includes flame retardant coating of the electrically conductive foam 102 to which the first layer of mesh 104 was laminated in the first step. In this example, the flame retardant treatment is performed at a temperature within a range from about 70°C to about 80°C, a speed within a range from about 2 feet per minute to about 4 feet per minute, and with a nip pressure within a range from about 7 pounds per square inch to about 10 pounds per square inch. In this example, the electrically conductive foam 102 undergoes a flame retardant treatment after one of the two plated mesh layers 104 is laminated to the electrically conductive foam 102. In other exemplary embodiments, the electrically conductive foam 102 may first undergo flame retardant treatment before any plated mesh layer 104 is laminated to the electrically conductive foam 102. In still other exemplary embodiments, the electrically conductive foam 102 may not undergo flame retardant treatment until after both of the two plated mesh layers 104 are laminated to the electrically conductive foam 102.

A third step, process, or operation includes laminating the second, remaining one of the two layers of plated mesh 104 to the opposite side of the electrically conductive foam 102. In this example, the laminating is performed using a flatbed laminator at a temperature within a range from about 140°C to about 160°C, a speed within a range from about 3 meters per minute to about 6 meters per minute, and with gaps between the belts or rollers within a range from about 1 millimeter to about 5 millimeters.

Some exemplary embodiments may further include a fourth step, process, or operation that include slitting, die cutting, or otherwise resizing and shaping the end product or electrically conductive, flame retardant material 100. For example, the electrically conductive, flame retardant material 100 may be slit and die cut into several smaller pieces to meet a particular customers requirements. The particular size and/or shape may depend on the product size and customer requirements such that the size and shape are not fixed process parameters.

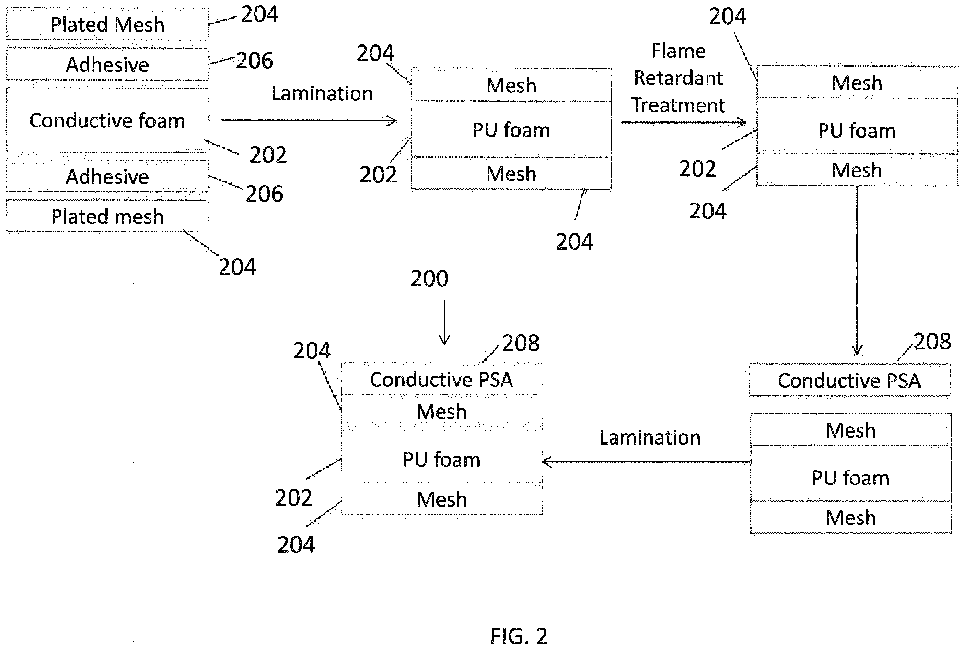

With reference now to FIG. 2, there is shown a second exemplary embodiment of an electrically conductive porous material assembly (or laminated stack of materials) 200 and exemplary method of making or producing the same, which embody one or more aspects of the present disclosure. As shown, the electrically conductive porous material assembly 200 includes conductive foam 202, first and second layers of plated mesh 204 on or along opposite sides of the foam 202, and first and second layers of adhesive 206 between the electrically conductive foam 202 and the respective first and second layers of plated mesh 204.

In this example, the electrically conductive porous material assembly 200 also undergoes a flame retardant treatment as disclosed herein. By way of example only, the flame retardant treatment in this example method may be similar or identical to a flame retardant coating process described in U.S. Patent 7,060,348 by which the electrically conductive foam is UL V-0 and halogen free. The entire disclosure of U.S. Patent 7,060,348 is incorporated herein by reference.

In this exemplary embodiment, the electrically conductive porous material assembly 200 further includes a layer of electrically conductive pressure sensitive adhesive (PSA) 208 on or along the first or upper layer of plated mesh 204. In operation, the electrically conductive PSA 208 may be used for adhesively attaching the electrically conductive porous material assembly 200 to a support surface, such as a surface of a customer's product, *e.g.,* electronic device, *etc.* By way of example, the electrically conductive PSA 208 may comprise a 0.07 millimeter (+/- .01 mm) thick unsupported acrylic pressure sensitive transfer adhesive with anisotropic electrical conductivity through the Z-axis (adhesive thickness), which provides good stick and shear properties to a wide variety of substrates, and extremely low electrical resistance (*e.g.,* Z-axis resistance less than .05 ohms, *etc.).* The PSA may be RoHS compliant and halogen free as defined herein. The PSA may provide excellent adhesion (*e.g.,* peel adhesion greater than 12 Newtons per 25 mm, *etc.)* to many metals and plastics, excellent in long term adhesion, well-balanced adhesion and cohesion properties, and extremely low electrical resistance. The PSA may be applied to a preferably clean, dry, well unified bonding surface at an application temperature range of 21 °C to 38°C and at high pressure by loading, fixture, hands, *etc.*

In FIG. 2, the layer of electrically conductive PSA 208 is shown on or along only the first or upper layer of plated mesh 204. In other exemplary embodiments, electrically conductive PSA 208 may additionally be disposed on or along the second or lower layer of plated mesh 204, such that there are two layers, *i.e.,* upper and lower layers, of electrically conductive PSA 208. In still other exemplary embodiments, the electrically conductive PSA 208 may only be disposed on or along the second or lower layer of plated mesh 204, such that there is no layer of electrically conductive PSA 208 on the first or upper layer of plated mesh 204. Still further exemplary embodiments (*e.g.,* electrically conductive porous material assembly 100, *etc.)* do not include any electrically conductive PSA on or along the plated mesh 204.

With continued reference to FIG. 2, the example operational parameters for laminating and flame retardant treatment provided above for the electrically conductive porous material assembly 100 may also be used for the electrically conductive porous material assembly 200. In this second exemplary embodiment, however, there is also an additional step, process or operation in which the electrically conductive PSA 208 is laminated to the first or upper layer of plated mesh 204 after the flame retardant treatment.

This additional lamination step for the electrically conductive PSA 208 may occur after both layers of plated mesh 204 have already been laminated to the electrically conductive foam 202 and after the flame retardant treatment, but before the end product or electrically conductive porous material assembly is slit die cut, or otherwise resized and shaped. Laminating of the electrically conductive PSA 208 to the first or upper layer of plated mesh 204 may be performed at room temperature or a temperature within a range from about 70°C to about 90°C, a speed within a range from about 4 meters per minute to about 8 meters per minute, and with gaps between the belts or rollers within a range from about 1 millimeter to about 5 millimeters.

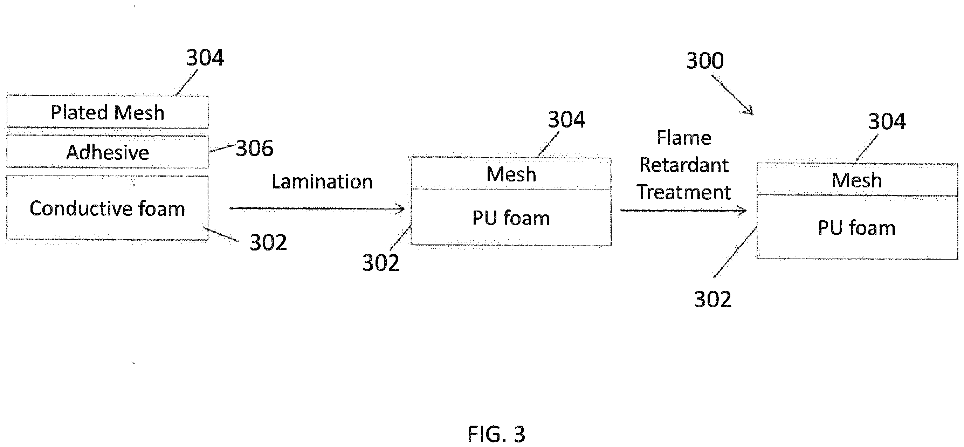

With reference now to FIG. 3, there is shown a third exemplary embodiment of an electrically conductive porous material assembly (or laminated stack of materials) 300 and exemplary method of making or producing the same, which embody one or more aspects of the present disclosure. As shown, the electrically conductive porous material assembly 300 includes conductive foam 302, plated mesh 304 on or along one side of the foam 302, and adhesive 306 between the electrically conductive foam 302 and the plated mesh 304.

The example operational parameters for laminating and flame retardant treatment provided above for the electrically conductive porous material assemblies 100, 200 may also be used for the electrically conductive porous material assembly 300. In this third exemplary embodiment, however, there is plated mesh 304 on or along only one side of the foam 302. Accordingly, this exemplary embodiment does not include a step, process, or operation for laminating plated mesh to a second side of the foam 304.

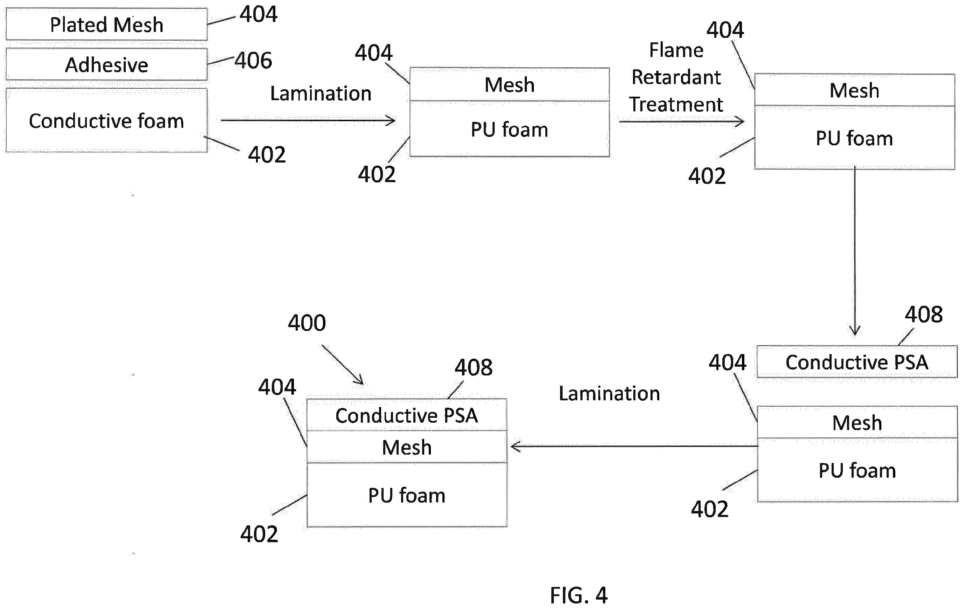

FIG. 4 shows a fourth exemplary embodiment of an electrically conductive porous material assembly (or laminated stack of materials) 400 and exemplary method of making or producing the same, which embody one or more aspects of the present disclosure. As shown, the electrically conductive porous material assembly 400 includes conductive foam 402, plated mesh 404 on or along one side of the foam 402, and adhesive 406 between the electrically conductive foam 402 and the plated mesh 404.

Similar to the exemplary embodiment shown in FIG. 2, the electrically conductive porous material assembly 400 further includes a layer of electrically conductive pressure sensitive adhesive (PSA) 408 on or along (*e.g.,* laminated to, *etc.)* the layer of plated mesh 404. In operation, the electrically conductive PSA 408 may be used for adhesively attaching the electrically conductive porous material assembly 400 to a support surface, such as a surface of a customer's product, *e.g.,* electronic device, *etc.* In this fourth exemplary embodiment, the electrically conductive PSA 408 is laminated to the layer of plated mesh 404 after the flame retardant treatment.

The example electrically conductive PSA 208 described above for the electrically conductive porous material assemblies 200 may also be used for the electrically conductive PSA 408 of the electrically conductive porous material assembly 400. The example operational parameters for laminating and flame retardant treatment provided above for the electrically conductive porous material assemblies 100, 200 may also be used for the electrically conductive porous material assembly 400.

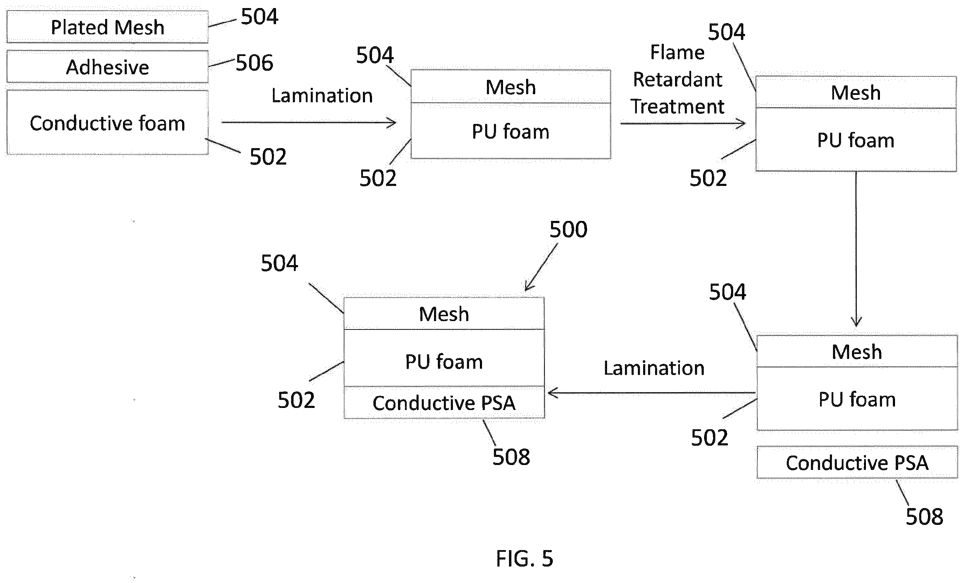

FIG. 5 shows a fifth exemplary embodiment of an electrically conductive porous material assembly (or laminated stack of materials) 500 and exemplary method of making or producing the same, which embody one or more aspects of the present disclosure. As shown, the electrically conductive porous material assembly 500 includes conductive foam 502, plated mesh 504 on or along one side of the foam 502, and adhesive 506 between the electrically conductive foam 502 and the plated mesh 504.

Similar to the exemplary embodiments shown in FIGS. 2 and 4, the electrically conductive porous material assembly 500 further includes a layer of electrically conductive pressure sensitive adhesive (PSA) 508. But in this fifth exemplary embodiment, the electrically conductive PSA 508 is on or along the conductive foam 502. In operation, the electrically conductive PSA 508 may be used for adhesively attaching the electrically conductive porous material assembly 500 to a support surface, such as a surface of a customer's product, *e.g.,* electronic device, *etc.* In this fifth exemplary embodiment, the electrically conductive PSA 508 is laminated to the conductive foam 502 after the flame retardant treatment.

The example electrically conductive PSA 208 described above for the electrically conductive porous material assemblies 200 may also be used for the electrically conductive PSA 508 of the electrically conductive porous material assembly 500. The example operational parameters for laminating and flame retardant treatment provided above for the electrically conductive porous material assemblies 100, 200 may also be used for the electrically conductive porous material assembly 500.

A wide range of materials may be used for the electrically conductive porous material *(e.g.,* foam 102, 202, 302, 402, 502, *etc.),* electrically conductive porous fabric *(e.g.,* plated mesh 104, 204, 304, 404, 504, *etc.)* and adhesive *(e.g.,* adhesive 106, 206, 306, 406, 506, *etc.)* in exemplary embodiments disclosed herein. By way of example, the electrically conductive porous material may comprise polyurethane open cell foam having internal interstices where the internal surfaces of the interstices are electrically conductive due to at least one electrically conductive layer (*e.g.,* metallized layer, metal plating, *etc.)* being disposed on internal surfaces of the interstices. A wide range of electrically conductive materials may be used for the electrically conductive layer on the foam, including copper, nickel, silver, palladium, platinum, nickel-plated silver, aluminum, tin, alloys thereof, *etc.*

The adhesive layers (*e.g.,* adhesive 106, 206, 306, 406, 506, *etc.)* may comprise lightweight, hot melt web adhesive. The adhesive is preferably lightweight and open enough to allow electrical contact between the plated foam and the outer mesh layers. In an exemplary embodiment, the adhesive layer(s) comprise polyamide hot melt adhesive web film, which may have, for example, high bond strength, good softness, washing resistance, solvent resistance, ecofriendly or green without harmful substances. By way of further example, the adhesive may comprise a polyamide hot melt adhesive web film having a basis weight of 8 grams to 120 grams, a width of 1 centimeter to 2.8 meters, a melting temperature of 125°C +/- 3°C, a washing temperature of 40°C, dry-clean good, lamination temperature of 120°C to 150°C, lamination time of 8 seconds to 15 seconds, and pressure of 2.5 bars to 3.5 bars.

The electrically conductive porous fabric may comprise a metalized or metal plated mesh fabric, such as nickel and copper plated taffeta fabric, nickel and copper plated ripstop fabric, and/or a nickel metal plated fabric from Laird Technologies, Inc. One exemplary embodiment includes two pieces of Laird's Flectron® metallized fabric, which includes nickel and copper plated fabric in which nickel is plated over a base layer of copper previously plated on the fabric. In use, the base layer of copper is highly electrically conductive copper while the outer layer of nickel provides corrosion resistance. Alternative embodiments may include different materials, such as different porous materials other than polyurethane foam, different porous fabrics other than mesh *(e.g.,* woven, non-woven, knotted, or knitted fabrics, other materials having an open texture, *etc.),* different metal platings, and/or different adhesives.

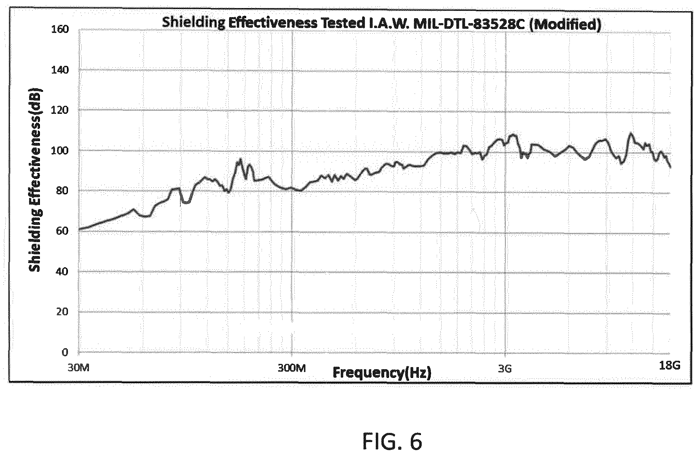

In an exemplary embodiment, the electrically conductive porous material assembly (*e.g*., similar to assembly 100, *etc*.) has a surface resistivity of 0.10 ohms per square or less (*e.g*., 0.07 ohms per square, *etc*.) and a bulk resistivity of 20 ohm•cm or less. Continuing with this example, this exemplary embodiment of the electrically conductive porous material assembly also has an average shielding effectiveness of 60 decibels or more. For example, FIG. 6 is a line graph showing shielding effectiveness in decibels (dB) versus frequency in hertz (Hz) measured per MIL-DTL-83528C (modified) for an exemplary embodiment of an electrically conductive flame retardant porous material assembly, which test results show shielding effective of 60 decibels or more for a frequency range of 30 megahertz (MHz) to 18 gigahertz (GHz). In other embodiments, the electrically conductive porous material assembly may be configured differently, such that its surface resistivity, bulk resistivity, and/or average shielding effectiveness is higher or lower than the values provided in this paragraph.

Accordingly, exemplary embodiments of the present disclosure provide flame retardant electrically conductive EMI shielding materials, which include porous materials having internal interstices where the internal surfaces of the interstices are electrically conductive, and contain an effective amount of flame retardant. In various exemplary embodiments, the flame retardant is in the form of a particulate dispersed throughout the interstices of the shielding material which particulate is adhered to the internal surfaces. In such embodiments, the particulate preferably occupies less than a majority (*e.g.,* no more than about 30%, no more than about 20%, no more than about 10%, *etc.)* of the total internal surface area defined by the interstices. In other exemplary embodiments, the flame retardant is in the form of a relatively thin coating on the internal surfaces of the interstices, which coating may have a thickness of about 12 microns or less, about 5 microns or less, about 2 microns or less, *etc.* In exemplary embodiments, the electrically conductive porous material is substantially free of occluded interstices, *e.g.,* less than a majority *(e.g.,* less than 25 percent, less than 10 percent, *etc.)* of the interstices (or pores) of the porous material are occluded or blocked.

Exemplary embodiments of the electrically conductive porous material assembly disclosed herein may be used as shielding materials that advantageously exhibit flame retardance *(e.g.,* UL-V-0, *etc.),* a satisfactory or good shielding effectiveness (*e.g.,* an average shielding effectiveness of at least about 65 decibels, *etc.),* and a satisfactory or good bulk resistance *(e.g.,* bulk resistivity (when compressed by 50 percent) of about 20 ohm•cm or less, about 1 ohm•cm about 0.05 ohm•cm or less, *etc*.). By way of background, shielding effectiveness is a measure of the attenuation of a signal transmitted through the material. In exemplary embodiments, an electrically conductive porous material assembly disclosed herein may exhibit an average shielding effectiveness of at least 65 decibels (dB), at least about 80 dB, at least about 90 dB, *etc.* as measured from 1 Megahertz (MHz) to 1 Gigahertz (GHz) by a transfer impedance test.

In preferred exemplary embodiments, the flame retardant is halogen free as defined by industry standards. In addition, other components *(e.g.,* conductive foam, plated mesh, adhesive, *etc.)* of the electrically conductive porous material assembly are also preferably halogen free. Accordingly, example embodiments of the electrically conductive porous material assemblies disclosed herein may be considered environmentally friendly and viewed as halogen-free per the industry standards. For example, example embodiments herein may be viewed as halogen-free per International Electrotechnical Commission (IEC) International Standard IEC 61249-2-21 (page 15, November 2003, First Edition). International Standard IEC 61249-2-21 defines "halogen free" (or free of halogen) for Electrical and Electronic Equipment Covered Under the European Union's Restriction of Hazardous Substances (RoHS) directive as having no more than a maximum of 900 parts per million chlorine, no more than a maximum of 900 parts per million bromine, and no more than a maximum of 1,500 parts per million total halogens. The phrases "halogen free," "free of halogen," and the like are similarly used herein.

The flame retardant treatment disclosed herein may include impregnating a porous material having internal interstices (the internal surfaces of which are electrically conductive) with a flame retardant to provide an effective amount of the flame retardant on the internal surfaces of the interstices. The flame retardant may be in the form of an aqueous composition, which can optionally include a polymeric carrier *(e.g.,* polyurethane, *etc.)* such as water-soluble or water-dispersible polymer. The solvent for the aqueous composition may be water and water-miscible organic solvents and can optionally be free of a non-water-miscible organic solvent. The method may include curing the impregnated porous material. Advantageously, this may provide an effective amount of the flame retardant without a substantial degradation of electrical properties and without a significant increase in bulk resistivity, e.g., results in no more than about a 10 fold increase in bulk resistivity, no more than a 1 fold increase in bulk resistivity, *etc.* Accordingly, exemplary embodiments are provided of flame retardant electrically conductive porous EMI shielding materials that exhibit flame retardance without a substantial decrease in shielding capacity.

By way of further example, a flame retardant that can be used is a phosphate-based flame retardant, such as an ammonium phosphate salt. In an exemplary embodiment, the flame retardant does not include red phosphorus flame retardant or expandable carbon graphite, and has no more than a maximum of about 1,000 parts per million of antimony. The flame retardant can optionally include a polymeric carrier (*e.g.,* polyurethane) such as water-soluble or water-dispersible polymer. Flame retardants that can be used include any flame retardant, such as halogen-based and non-halogen based flame retardants. In one embodiment, a phosphate-based flame retardant is used. Examples of phosphate-based flame retardants that can be used are ammonium phosphates, alkyl phosphates, phosphonate compounds, combinations thereof, *etc.* Representative examples of flame retardants that can be used include decabromodiphenyloxide, decabromodiphenylether, antimony trioxide, hexabromocyclododecane, ethylenebis-(tetrabromophthalimide), chlorinated parrafin, bis(hexachlorocyclopentadieno)cyclooctane, aluminum trihydrate, magnesium hydroxide, zinc borate, zinc oxidetri-(1,3-dicholoroisopropyl) phosphate, phosphonic acid, oligomeric phosphonate, ammonium polyphosphate (APP), ammonium dihydrogen phosphate (ADP), triphenyl phosphate (TPP), diammonium and monoammonium phosphate salt or any mixture thereof. In exemplary embodiments, the flame retardant is free or substantially free of halogens to provide a halogen-free flame retardant material. Particular examples of commercially available flame retardants are sold by Clariant Corporation located in Germany, Apex Chemical Company located in Spartanburg, South Carolina, and Akzo Nobel located in Dobbs Ferry, New York.

Foams and other porous materials have internal interstices (or pores). The internal surfaces of the interstices (or pores) define an "internal surface area" through an interconnected network of interstices or pores exhibited throughout the material. In exemplary embodiments disclosed herein, the porous material may be an open cell polymeric foam, such as foam made from a thermoplastic elastomer (*e.g.,* polyurethane foam, *etc.).* In such exemplary embodiments, polymeric foams have an advantageously deformable nature, which is beneficial for certain shielding applications. In some exemplary embodiments, the porous material is a foam having about 5 to 120 pores per inch, about 50 to 70 pores per inch, *etc.*

The internal surfaces of the porous materials (*e.g.,* conductive foam 102, 202, 302, 402, 502, *etc.)* may be rendered electrically conductive by depositing at least one layer of an electrically conductive material throughout the internal surface area of the material. Electrically conductive in shielding applications may mean a surface resistivity of about 300 ohm/square or less. The electrically conductive material can be in the form of an electrically conductive filler, a metal layer, or an electrically conductive non-metal layer. Examples of electrically conductive fillers include carbon graphite, metal flakes, metal powder, metal wires, metal plated particles, combinations thereof, *etc.* The porous material may be impregnated with the filler to disperse the filler throughout the material. A metallized layer may be applied by plating or sputtering. Metals that may be used to render a porous material electrically conductive include copper, nickel, silver, palladium, platinum, nickel-plated-silver, aluminum, tin, alloys thereof, *etc.* Examples of non-metallic materials that can be used to render internal surface area of a porous material electrically conductive include inherently conductive polymers, such as d-polyacetylene, d-poly(phenylene vinylene), d-polyaniline, combinations thereof, *etc.*

In exemplary embodiments, the internal surfaces of the porous material are provided with an effective amount of a flame retardant. Stated otherwise, the flame retardant is dispersed throughout the material by being disposed on the surfaces of the interconnected interstices (or pores). In the context of the present disclosure, an "effective amount" is an amount of the flame retardant that provides the shielding material with at least horizontal flame rating while at the same time retaining a Z-axis conductivity or bulk resistivity sufficient for EMI shielding applications. The amount of the flame retardant dispersed throughout the porous material may be about 10 ounces per square yard (opsy) or less, about 5 opsy or less, about 3 opsy, *etc.*

In an exemplary embodiment, a polymeric coating is optionally disposed between the internal surface of the interstices (or pores) and the flame retardant. It has been advantageously found that the shielding material may be provided with a polymeric coating without a substantial increase in flammability. The amount provided to the shielding material is any amount that does not substantially decrease the shielding effectiveness of the material while at the same time increasing flammability. Examples of polymeric materials that can be used are homopolymers, copolymers, and mixtures thereof such as poly(ethylene), poly(phoshphazene), poly(acrylonitrile), poly(styrene), poly(butadiene), plasticized poly(vinyl chloride), polychloroprene (Neoprene), polycarbonate, poly(vinyl acetate), alkylcelluloses, poly(ethylene terephthalate), phosphate and polyphosphonate esters, epoxy resins, copolymers of styrene and maleic anhydride, melamine-formaldehyde resins, and urethanes. The polymeric material for the coating may be a water-soluble or water-dispersible polymer. In one particular embodiment, the internal surface area of the porous material is provided with a urethane polymer coating with a dried coating weight of less than about 1 ounce per square yard (opsy), less than about 0.6 opsy, *etc.* The actual amount of the polymeric coating is variable so long as the shielding effectiveness and flammability of the shielding material is not detrimentally affected.

In various embodiments, the flame retardant shielding materials are prepared by impregnating the above-described shielding materials with a flame retardant under conditions sufficient to dispose an effective amount of the flame retardant on the internal surfaces of the interstices. For example, the porous material can be immersed in a liquid composition containing the flame retardant. Other methods of impregnating the porous materials with flame retardant include spraying, air knife coating, top and bottom direct coating, slot die (extrusion) coating, knife over roll (gap) coating, metering rod coating, dual reverse roll coating, *etc.*

In an example, the porous material is impregnated by immersing the material in a liquid flame retardant composition of sufficient viscosity and for a time sufficient for the composition to diffuse throughout the material. The excess flame retardant is removed (*e.g.,* by nipping the impregnated material) to minimize the occurrence of occlusions, after which the impregnated material is cured by any technique known in the art. An aqueous composition may be used for impregnating a polymeric foam to minimize (or at least reduce) potential swelling of the foam material. "Aqueous" means that the majority of the solvent for the liquid composition is water or a combination of water and water-miscible organic solvents. The solvent may be free of non-water-miscible organic solvents. In an exemplary embodiment, curing is effected by drying the material (*e.g.,* at ambient temperature or with an oven) with the choice of curing means being dependent on the components contained in the composition.

Liquid flame retardant compositions that can be used for impregnating the foam material are available from various suppliers such as Clariant Corporation, Apex Chemical Company and Akzo Nobel, which are described herein. The viscosity of the liquid composition should be sufficiently low to readily diffuse and permeate through the porous material. For example, the liquid flame retardant composition may have a viscosity of about 1000 centipoise per second (cps) or less, about 500 cps or less about 100 cps or less, *etc.* The viscosity of the flame retardant may be adjusted to facilitate diffusion throughout the porous material in addition to altering coating weights. Optionally, liquid composition can also include a wetting agent to facilitate diffusion of the flame retardant composition. Wetting agents that can be used include, surfactants (*e.g.,* cationic, anionic, non-ionic and zwitterionic). The wetting agent can be incorporated in the composition in an amount of about ten percent by weight or less, about four percent by weight or less, about two percent by weight or less, *etc.*

In an exemplary embodiment, the liquid flame retardant composition may also include a polymeric carrier to facilitate the formation of a thin flame retardant coating on the internal surfaces of the interstices (or pores) of the porous shielding material. Polymeric carriers that can be used include water-soluble or water-dispersible polymers. In an exemplary embodiment, a water-based urethane polymer composition may be utilized. The ratio of flame retardant to polymeric carrier may range from about 1:1 to about 5:1 on a dried weight basis, a ratio of about 2:1 to about 3:1 on a dried weight basis, *etc.*

As previously described, a porous material can be optionally provided with a polymeric coating without increasing flammability of the shielding material. In an exemplary embodiment, the shielding material is first impregnated with the polymeric coating composition. The excess polymeric coating material is removed from the impregnated shielding material to minimize (or at least significantly reduce) occluded interstices and optionally cured (*e.g.,* dried) prior to the application of the flame retardant.

The step, operation, or process of impregnating the porous material with the flame retardant results in flame retardant dispersed throughout the porous material. The method of providing the porous material with the flame retardant may result in no more than a 10 fold increase in bulk resistivity for the shielding material, no more than about a 1 fold increase in bulk resistivity, no more than a 0.1 fold increase, *etc.* Average shielding effectiveness of the porous material provided with the flame retardant may decrease by no more than 30 percent, decrease by 20 percent or less, decrease by 10 percent or less, *etc.*

As disclosed herein, example embodiments of the electrically conductive porous material assemblies are able to achieve desired flame ratings per the industry standards. For example, exemplary embodiments are able to achieve Underwriters Laboratories Standard No. 94, "Tests for Flammability of Plastic Materials for Parts in Devices and Appliances" (5th Edition, October 29, 1996) (hereinafter, UL-94). For example, some electrically conductive porous material assemblies are able to achieve higher flame ratings of V-0. Other electrically conductive porous materials may only be able to achieve lower flame ratings, such as V-1, V-2, HB, or HF-1. The desired UL-94 flame rating of the example embodiments of the electrically conductive porous material assemblies can depend, for example, on the particular application or installation for the electrically conductive porous material assembly.

With that said, flame ratings can be determined using UL-94 or using an American Society for Testing and Materials (ASTM) flammability test. UL-94 includes flame ratings of V-0, V-1, V-2, HB, and HF-1, where V-0 is a higher flame rating and HF-1 is a lower flame rating. Notably, the V-0 rating is much more difficult to achieve than the V-1, V-2, HB, and HF-1 ratings. A sample product achieving a lower V-1 rating would not necessarily achieve a higher V-0 rating. Indeed, V-0 and V-1 ratings of sample products are treated as being mutually exclusive for the sample products and are not overlapping. In other words, a sample product identified as having a V-1 rating would not also be considered as having a V-0 rating (otherwise it would be identified as having a V-0 rating).

Under UL-94, flame ratings are determined for a sample product based on burn tests for sets of five specimens of the sample product. Table 1 indicates criteria used for determining UL-94 V-0, V-1, V-2 flame ratings. For example, to achieve a flame rating of V-0, afterflame time (t₁ or t₂) for each individual specimen of the sample product tested must be less than or equal to 10 seconds, total afterflame time (t₁ plus t₂ for all five specimens) must be less than or equal to 50 seconds, and afterflame plus afterglow time (t₂ plus t₃) for each individual specimen must be less than or equal to 30 seconds. At the least, each of these criteria must be satisfied to achieve a flame rating of V-0. As can be appreciated, the V-0 rating is much more difficult to achieve than the V-1 or V-2 ratings.

**Table 1**

| **UL-94 CRITERIA CONDITIONS** | **V-0** | **V-1** | **V-2** |
|---|---|---|---|
| Afterflame time for each individual specimen t₁ or t₂ | ≤10s | ≤30s | ≤30s |
| Total afterflame time for any condition set (t₁ plus t₂ for the five specimens) | ≤50s - | ≤250s - | ≤250s - |
| Afterflame plus afterglow time for each individual specimen after the second flame application (t₂ plus | ≤30s | ≤60s | ≤60s |
| Afterflame or afterglow of any specimen up to the holding clamp | No | No | No |
| Cotton indicator ignited by flaming particles or drops | No | No | Yes |

The tables below and FIGS. 6 through 9 include test results measured for test specimens of electrically conductive porous material assemblies produced in accordance with exemplary embodiments of the present disclosure. These test results are provided for purposes of illustration only and not for purposes of limitation.

The tables immediately below provide Z-axis resistance in ohms, flame retardant basis weights in ounces per square yard (OPSY), and flammability test results measured for 2 millimeter thick test specimens that included electrically conductive foam, double mesh (mesh along each of the first and second sides of the foam), 12 gram web adhesive, and flame retardant coating (APEX911 (50%) + 2% Antioxidant).

**Table 2: Z-Axis Resistance (in Ohms)**

| **Sample NO.** | | **1** | **2** | **3** | **Average** | **Remark** |
|---|---|---|---|---|---|---|
| | beginning | 0.016 | 0.017 | 0.014 | 0.016 | FR treatment |
| | end | 0.010 | 0.011 | 0.011 | 0.011 | |

**Table 3: Flame Retardant Basis Weight (in OPSY)**

| **Sample NO.** | **beginning** | **end** |
|---|---|---|
| **Single Mesh** | 2.56 | 2.75 |

**Tables 4 and 5: UL-94 V-0 Burn Test**

| | T1 | T2 | T3 | Pass/Fail |
|---|---|---|---|---|
| 1 | 0.00 | 0.00 | 0 | PASS |
| 2 | 0.00 | 0.00 | 0 | PASS |
| 3 | 0.00 | 0.00 | 0 | PASS |
| 4 | 0.00 | 0.00 | 0 | PASS |
| 5 | 0.00 | 0.00 | 0 | PASS |
| Total | | | | |
| Afterflame | 0.00 | | | |
| Test Result | PASS | | | |
| 1 | 0.00 | 0.00 | 0 | PASS |
| 2 | 0.00 | 0.00 | 0 | PASS |
| 3 | 0.00 | 0.00 | 0 | PASS |
| 4 | 0.00 | 0.00 | 0 | PASS |
| 5 | 6.49 | 0.00 | 0 | PASS |
| Total | | | | |
| Afterflame | 6.49 | | | |
| Test Result | PASS | | | |

FIG. 6 is a line graph showing shielding effectiveness in decibels (dB) versus frequency in hertz (Hz) measured per MIL-DTL-83528C (modified) for a 2 millimeter thick test specimen that included electrically conductive foam, double mesh (mesh along each of the first and second sides of the foam), 12 gram web adhesive, and flame retardant coating treatment by APEX911 (40%) + 2% Antioxidant. This specimen also achieved a flame rating of UL94 V-0. As shown by FIG. 6, this test specimen had a shielding effective of 60 decibels or more for the frequency range of 30 megahertz (MHz) to 18 gigahertz (GHz). For example, the test specimen had a shielding effectiveness of about 60 decibels at 30 MHz, about 80 decibels at 300 MHz, about 105 decibels at 3 GHz, and about 92 decibels at 18 GHz. In other embodiments, an electrically conductive porous material assembly may be configured differently, for example, such that it has a shielding effectiveness different, higher, or lower than what is shown in FIG. 6.

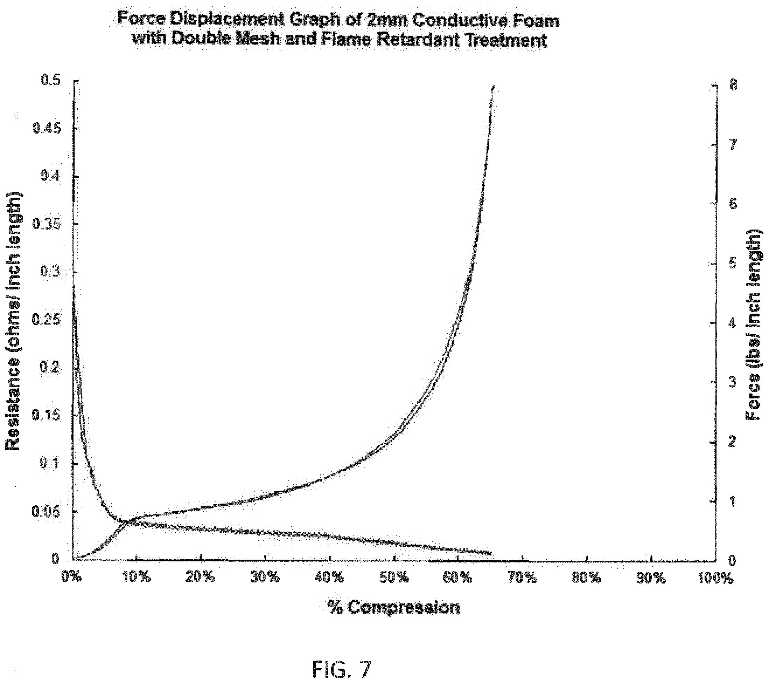

FIG. 7 is a force displacement resistance line graph showing resistance (in ohms per square inch) and force (pounds per square inch) versus percentage compression measured for two test specimens of electrically conductive flame retardant porous material assembly. For this particular testing, each test specimen was about 2.27 millimeters thick, had a weight of about 7.72 ounces per square yard, and a flame retardant coating weight of about 1.88 ounces per square yard. Each test specimen included electrically conductive foam, double mesh (e.g., plated mesh along each of the first and second sides of the foam), 12 gram hot melt adhesive, and a treatment or coating with a flame retardant solution of APEX911 (33%) + 2% Antioxidant. As shown by FIG. 7, the test specimens had good or satisfactory force displacement resistance results, e.g., Z-axis resistance equal to or less than 0.2 ohms per square inch at 50% compression. In this example, the test specimens had a Z-axis resistance of about 0.014 ohms per square inch at 50% compression. The test specimens also had a Z-axis resistance of about 0.2 ohms per square inch at about a 3% compression, which Z-axis resistance decreased for higher compression percentages. Continuing with this example, the two specimens also had a flame rating of UL94 V-0, surface resistivity of equal to or less than 0.5 ohms/square *(e.g.,* 0.192 ohms/square, *etc.),* adhesion strength equal to or more than .1 Newton per millimeter, a compression set percentage less than 30 (*e.g*., 23.8%, *etc.),* and did not have any creases. In other embodiments, an electrically conductive porous material assembly may be configured differently, such as with other materials, other flame retardant basis weights, with different thicknesses *(e.g.,* 2 millimeters thick +/- 0.5 millimeters, *etc.),* and/or such that it produces different test results.

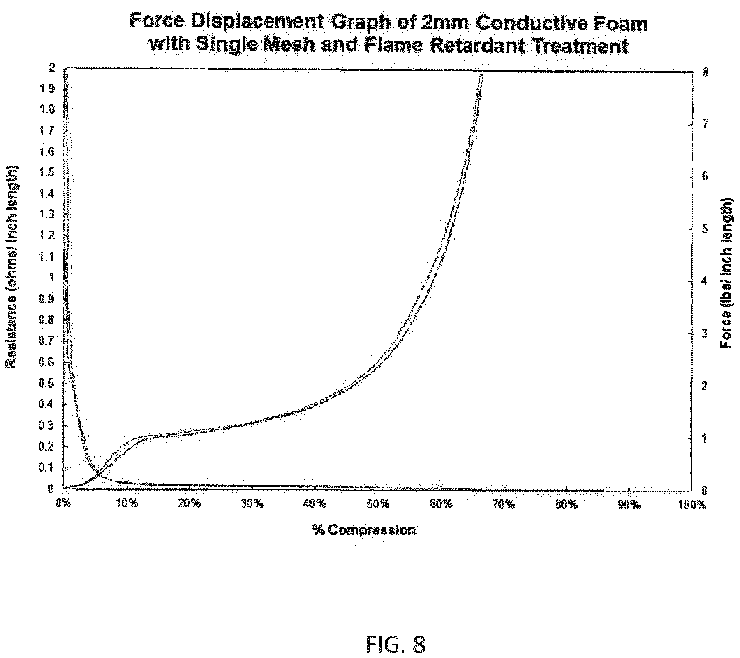

FIG. 8 is a force displacement resistance line graph showing resistance (in ohms per square inch) and force (pounds per square inch) versus percentage compression measured for two test specimens of an electrically conductive flame retardant porous material assembly. For this particular testing, each test specimen was about 2.25 millimeters thick, had a weight of about 6.19 ounces per square yard, and a flame retardant coating weight of about 1.89 ounces per square yard. Each test specimen included electrically conductive foam, single mesh (*e.g*., plated mesh along only one side of the foam), 12 gram hot melt adhesive, and a treatment or coating with a flame retardant solution of APEX911 (33%) + 2% Antioxidant. As shown by FIG. 8, the test specimens had good or satisfactory force displacement resistance results, *e.g.,* Z-axis resistance equal to or less than 0.2 ohms per square inch at 50% compression. In this example, the test specimens had a Z-axis resistance of about 0.019 ohms per square inch at 50% compression. The test specimens had a Z-axis resistance of about 0.2 ohms per square inch at about 5% compression, which Z-axis resistance decreased for higher compression percentages. Continuing with this example, the two specimens also achieved a flame rating of UL94 V-0 as shown by Table 6 below. The test specimens had a surface resistivity of equal to or less than 0.5 ohms/square *(e.g.,* 0.206 ohms/square, *etc.),* an adhesion strength of about .086 Newtons per millimeter, a compression set percentage less than 40% *(e.g.,* 37.6%, *etc.),* and did not have any creases. In other embodiments, an electrically conductive porous material assembly may be configured differently, such as with other materials, other flame retardant basis weights, with different thicknesses *(e.g.,* 2 millimeters thick +/- 0.5 millimeters, *etc.),* and/or such that it produces different test results.

**Table 6: UL-94 V-0 Burn Test**

| | T1 | T2 | T3 | Pass/Fail |
|---|---|---|---|---|
| 1 | 0.00 | 0.00 | 0 | PASS |
| 2 | 0.00 | 0.00 | 0 | PASS |
| 3 | 0.00 | 0.00 | 0 | PASS |
| 4 | 0.00 | 0.00 | 0 | PASS |
| 5 | 0.00 | 0.00 | 0 | PASS |
| Total | | | | |
| Afterflame | 0.00 | | | |
| Test Result | PASS | | | |

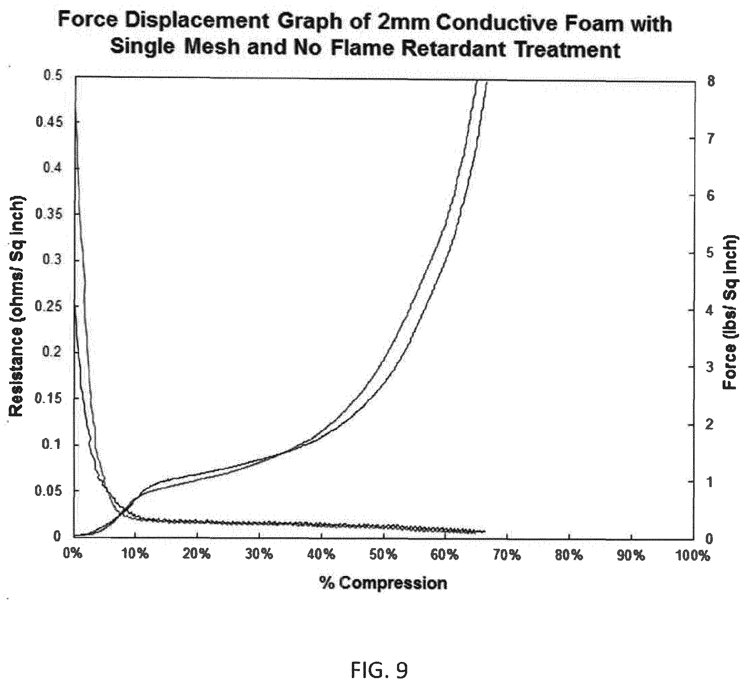

FIG. 9 is a force displacement resistance line graph showing resistance (in ohms per square inch) and force (pounds per square inch) versus percentage compression measured for two test specimens of electrically conductive flame retardant porous material assembly. For this particular testing, each test specimen was about 2 millimeters thick +/- 0.5 millimeters. Each test specimen included electrically conductive foam, single mesh (*e.g.,* plated mesh along only one side of foam) and 12 gram hot melt adhesive. For this particular testing, the test specimens were not coated or treated with flame retardant treatment. As shown by FIG. 9, the test specimens had good or satisfactory force displacement resistance results, e.g., Z-axis resistance equal to or less than 0.2 ohms per square inch at 50% compression.

Example embodiments are provided so that this disclosure will be thorough, and will fully convey the scope to those who are skilled in the art. Numerous specific details are set forth such as examples of specific components, devices, and methods, to provide a thorough understanding of embodiments of the present disclosure. It will be apparent to those skilled in the art that specific details need not be employed, that example embodiments may be embodied in many different forms, and that neither should be construed to limit the scope of the disclosure. In some example embodiments, well-known processes, well-known device structures, and well-known technologies are not described in detail. In addition, advantages and improvements that may be achieved with one or more exemplary embodiments of the present disclosure are provided for purpose of illustration only and do not limit the scope of the present disclosure, as exemplary embodiments disclosed herein may provide all or none of the above mentioned advantages and improvements and still fall within the scope of the present disclosure.

Specific dimensions, specific materials, and/or specific shapes disclosed herein are example in nature and do not limit the scope of the present disclosure. The disclosure herein of particular values and particular ranges of values for given parameters are not exclusive of other values and ranges of values that may be useful in one or more of the examples disclosed herein. Moreover, it is envisioned that any two particular values for a specific parameter stated herein may define the endpoints of a range of values that may be suitable for the given parameter (*i.e.,* the disclosure of a first value and a second value for a given parameter can be interpreted as disclosing that any value between the first and second values could also be employed for the given parameter). For example, if Parameter X is exemplified herein to have value A and also exemplified to have value Z, it is envisioned that parameter X may have a range of values from about A to about Z. Similarly, it is envisioned that disclosure of two or more ranges of values for a parameter (whether such ranges are nested, overlapping or distinct) subsume all possible combination of ranges for the value that might be claimed using endpoints of the disclosed ranges. For example, if parameter X is exemplified herein to have values in the range of 1 - 10, or 2 - 9, or 3 - 8, it is also envisioned that Parameter X may have other ranges of values including 1 - 9, 1 - 8, 1 - 3, 1 - 2, 2 - 10, 2 - 8, 2 - 3, 3 - 10, and 3 - 9.

The terminology used herein is for the purpose of describing particular example embodiments only and is not intended to be limiting. As used herein, the singular forms "a," "an," and "the" may be intended to include the plural forms as well, unless the context clearly indicates otherwise. The terms "comprises," "comprising," "including," and "having," are inclusive and therefore specify the presence of stated features, integers, steps, operations, elements, and/or components, but do not preclude the presence or addition of one or more other features, integers, steps, operations, elements, components, and/or groups thereof. The method steps, processes, and operations described herein are not to be construed as necessarily requiring their performance in the particular order discussed or illustrated, unless specifically identified as an order of performance. It is also to be understood that additional or alternative steps may be employed.

When an element or layer is referred to as being "on," "engaged to," "connected to," or "coupled to" another element or layer, it may be directly on, engaged, connected or coupled to the other element or layer, or intervening elements or layers may be present. In contrast, when an element is referred to as being "directly on," "directly engaged to," "directly connected to," or "directly coupled to" another element or layer, there may be no intervening elements or layers present. Other words used to describe the relationship between elements should be interpreted in a like fashion (*e.g.,* "between" versus "directly between," "adjacent" versus "directly adjacent," *etc.).* As used herein, the term "and/or" includes any and all combinations of one or more of the associated listed items.

The term "about" when applied to values indicates that the calculation or the measurement allows some slight imprecision in the value (with some approach to exactness in the value; approximately or reasonably close to the value; nearly). If, for some reason, the imprecision provided by "about" is not otherwise understood in the art with this ordinary meaning, then "about" as used herein indicates at least variations that may arise from ordinary methods of measuring or using such parameters. For example, the terms "generally," "about," and "substantially," may be used herein to mean within manufacturing tolerances. Or for example, the term "about" as used herein when modifying a quantity of an ingredient or reactant of the invention or employed refers to variation in the numerical quantity that can happen through typical measuring and handling procedures used, for example, when making concentrates or solutions in the real world through inadvertent error in these procedures; through differences in the manufacture, source, or purity of the ingredients employed to make the compositions or carry out the methods; and the like. The term "about" also encompasses amounts that differ due to different equilibrium conditions for a composition resulting from a particular initial mixture. Whether or not modified by the term "about," the claims include equivalents to the quantities.

Although the terms first, second, third, *etc.* may be used herein to describe various elements, components, regions, layers and/or sections, these elements, components, regions, layers and/or sections should not be limited by these terms. These terms may be only used to distinguish one element, component, region, layer or section from another region, layer or section. Terms such as "first," "second," and other numerical terms when used herein do not imply a sequence or order unless clearly indicated by the context. Thus, a first element, component, region, layer or section discussed below could be termed a second element, component, region, layer or section without departing from the teachings of the example embodiments.

Spatially relative terms, such as "inner," "outer," "beneath," "below," "lower," "above," "upper" and the like, may be used herein for ease of description to describe one element or feature's relationship to another element(s) or feature(s) as illustrated in the figures. Spatially relative terms may be intended to encompass different orientations of the device in use or operation in addition to the orientation depicted in the figures. For example, if the device in the figures is turned over, elements described as "below" or "beneath" other elements or features would then be oriented "above" the other elements or features. Thus, the example term "below" can encompass both an orientation of above and below. The device may be otherwise oriented (rotated 90 degrees or at other orientations) and the spatially relative descriptors used herein interpreted accordingly.

The foregoing description of the embodiments has been provided for purposes of illustration and description. It is not intended to be exhaustive or to limit the disclosure. Individual elements, intended or stated uses, or features of a particular embodiment are generally not limited to that particular embodiment, but, where applicable, are interchangeable and can be used in a selected embodiment, even if not specifically shown or described. The same may also be varied in many ways. Such variations are only limited by the scope of the claims.

## Claims

1. An electrically conductive porous material assembly (100, 200, 300, 400, 500) comprising:
an electrically conductive porous material (102); a first layer of electrically conductive porous fabric (104); a first layer of hot melt web adhesive (106, 206, 306, 406, 506) between the first layer of electrically conductive porous fabric and the electrically conductive porous material; and
wherein the first layer of hot melt web adhesive is open enough to allow electrical contact between the first layer of electrically conductive porous fabric and the electrically conductive porous material whereby the electrically conductive porous material assembly has Z-axis conductivity through the first layer of electrically conductive porous fabric, the first layer of hot melt web adhesive, and the electrically conductive porous material;
whereby:
the electrically conductive porous fabric and/or the electrically conductive porous material are electrically conductive without requiring the use of silver; and/or
the electrically conductive porous material assembly has a flame rating of V-0 under Underwriter's Laboratories (UL) Standard No. 94, and the electrically conductive porous material assembly has no more than a maximum of 900 parts per million chlorine, no more than a maximum of 900 parts per million bromine, and no more than a maximum of 1,500 parts per million total halogens.

2. The electrically conductive porous material assembly of claim 1, further comprising a flame retardant applied to the electrically conductive porous material such that the electrically conductive porous material assembly has a flame rating of V-0 under Underwriter's Laboratories (UL) Standard No. 94, wherein the electrically conductive porous material assembly has no more than a maximum of 900 parts per million chlorine, no more than a maximum of 900 parts per million bromine, and no more than a maximum of 1,500 parts per million total halogens.

3. The electrically conductive porous material assembly of any one of the preceding claims, wherein the electrically conductive porous fabric and/or the electrically conductive porous material are electrically conductive without the use of silver.

4. The electrically conductive porous material assembly of any one of the preceding claims, further comprising:
a second layer of electrically conductive porous fabric; and
a second layer of hot melt web adhesive between the second layer of electrically conductive porous fabric and the electrically conductive porous material;
wherein the electrically conductive porous material assembly has Z-axis conductivity from top to bottom through the first layer of electrically conductive porous fabric, the first layer of hot melt web adhesive, the electrically conductive porous material, the second layer of hot melt web adhesive, and the second layer of electrically conductive porous fabric.

5. The electrically conductive porous material assembly of claim 4, wherein:
the electrically conductive porous material comprises electrically conductive plated foam;
the first and second layers of electrically conductive porous fabric comprise first and second layers of plated mesh; and
the first and second layers of hot melt web adhesive melt to bond the respective first and second layers of plated mesh to the electrically conductive plated foam and to allow the first and second layers of plated mesh to contact the electrically conductive foam and keep electrical flow from top to bottom through the first layer of plated mesh, the first layer of hot melt web adhesive, the electrically conductive plated foam, the second layer of hot melt web adhesive, and the second layer of plated mesh, while also holding the first and second layers of plated mesh and plated foam together.

6. The electrically conductive porous material assembly of claim 5, wherein:
the electrically conductive plated foam comprises polyurethane open-cell foam plated with metal; and
the first and second layers of plated mesh comprise first and second layers of metalized fabric.

7. The electrically conductive porous material assembly of any one of claims 4 to 6, wherein the first and second layers of hot melt web adhesive allows the first and second layers of electrically conductive porous fabric to contact the electrically conductive porous material and keep electrical flow from top to bottom through the first layer of electrically conductive porous fabric, the first layer of hot melt web adhesive, the electrically conductive porous material, the second layer of hot melt web adhesive, and the second layer of electrically conductive porous fabric, while also holding the first and second layers of electrically conductive porous fabric and electrically conductive porous material together.

8. The electrically conductive porous material assembly of any one of the preceding claims, wherein:
the electrically conductive porous material assembly does not include silver; and
the hot melt web adhesive comprises a polyamide hot melt adhesive web film.

9. The electrically conductive porous material assembly of any one of the preceding claims, wherein:
the electrically conductive porous material includes internal interstices having internal surfaces which are electrically conductive due to at least one electrically conductive metal or non-metal layer disposed on the internal surfaces; and
a flame retardant is within the internal interstices to provide the electrically conductive porous material with at least horizontal flame rating and such that the electrically conductive porous material is substantially free of occluded interstices.

10. The electrically conductive porous material assembly of any one of the preceding claims, wherein:
the electrically conductive porous material assembly has a surface resistivity of 0.10 ohms per square or less;
the electrically conductive porous material assembly has a bulk resistivity of 20 ohm•cm or less; and
the electrically conductive porous material assembly has an average shielding effectiveness of 60 decibels or more.

11. The electrically conductive porous material assembly of any one of the preceding claims, wherein the electrically conductive porous material assembly has no more than a maximum of 50 parts per million chlorine and no more than a maximum of 50 parts per million bromine.

12. The electrically conductive porous material assembly of any one of the preceding claims; wherein:
the electrically conductive porous material comprises electrically conductive foam;
the electrically conductive porous fabric comprise plated mesh; and
the electrically conductive porous material assembly does not include silver.

13. An electrically conductive EMI shield comprising the electrically conductive porous material assembly of any one of the preceding claims, wherein:
the electrically conductive EMI shield has a flame rating of V-0 under Underwriter's Laboratories (UL) Standard No. 94; and
the electrically conductive EMI shield has no more than a maximum of 900 parts per million chlorine, no more than a maximum of 900 parts per million bromine, and no more than a maximum of 1,500 parts per million total halogens; and
the electrically conductive porous material comprises electrically conductive plated foam;
the electrically conductive porous fabric comprises plated mesh that is laminated to the electrically conductive plated foam; and
the hot melt web adhesive adhesively attaches the plated mesh to the electrically conductive plated foam with Z-axis contact therebetween.

14. A method of making an electrically conductive porous material assembly (100, 200, 300, 400, 500), the method comprising adhesively attaching a first layer of electrically conductive porous fabric (104, 204, 304, 404, 504) to a first side of an electrically conductive porous material (102, 202, 302, 402, 502) by using a first layer of hot melt web adhesive (106, 206, 306, 406, 506) between the first layer of electrically conductive porous fabric and the electrically conductive porous material, wherein the first layer of hot melt web adhesive is open enough to allow electrical contact between the first layer of electrically conductive porous fabric and the electrically conductive porous material, whereby the electrically conductive porous material assembly has Z-axis conductivity through the first layer of electrically conductive porous fabric, the first layer of hot melt web adhesive, and the electrically conductive porous material.

15. The method of claim 14, further comprising attaching a second layer of electrically conductive porous fabric to a second side of the electrically conductive porous material by using a lamination process and a second layer of hot melt web adhesive between the second layer of electrically conductive porous fabric and the electrically conductive porous material, whereby the electrically conductive porous material assembly has Z-axis conductivity from top to bottom through the first layer of electrically conductive porous fabric, the first layer of hot melt web adhesive, the electrically conductive porous material, the second layer of hot melt web adhesive, and the second layer of electrically conductive porous fabric.

16. The method of claim 14 or 15, wherein the step of adhesively attaching the first layer of electrically conductive porous fabric to the first side of the electrically conductive porous material is performed after the porous fabric has already been plated to provide the first layer of electrically conductive porous fabric and after the porous material has already been plated to provide the electrically conductive porous material.

## Patentansprüche

1. Baugruppe aus elektrisch leitfähigem porösem Material (100, 200, 300, 400, 500), die Folgendes umfasst:
ein elektrisch leitfähiges poröses Material (102),
eine erste Schicht aus elektrisch leitfähigem porösem Gewebe (104),
eine erste Schicht aus Heißschmelzbahnklebstoff (106, 206, 306, 406, 506) zwischen der ersten Schicht aus elektrisch leitfähigem porösem Gewebe und dem elektrisch leitfähigen porösen Material, und
wobei die erste Schicht aus Heißschmelzbahnklebstoff offen genug ist, um einen elektrischen Kontakt zwischen der ersten Schicht aus elektrisch leitfähigem porösem Gewebe und dem elektrisch leitfähigen porösem Material zu gestatten, wobei die Baugruppe aus elektrisch leitfähigem porösem Material eine Z-Achsen-Leitfähigkeit durch die erste Schicht aus elektrisch leitfähigem porösem Gewebe, die erste Schicht aus Heißschmelzbahnklebstoff und das elektrisch leitfähige poröse Material hindurch besitzt,
wobei:
das elektrisch leitfähige poröse Gewebe und/oder das elektrisch leitfähige poröse Material elektrisch leitfähig sind, ohne dass die Verwendung von Silber erforderlich wäre, und/oder
Baugruppe aus elektrisch leitfähigem porösem Material eine Flammeinstufung von V-0 gemäß Underwriters Laboratories (UL)-Standard Nr. 94 aufweist, und Baugruppe aus elektrisch leitfähigem porösem Material nicht mehr als maximal 900 Teile pro Million Chlor, nicht mehr als maximal 900 Teile pro Million Brom und nicht mehr als maximal 1.500 Teile pro Million Gesamthalogene aufweist.

2. Baugruppe aus elektrisch leitfähigem porösem Material nach Anspruch 1, die des Weiteren einen Flammhemmer umfasst, der so auf das elektrisch leitfähige poröse Material aufgebracht wird, dass Baugruppe aus elektrisch leitfähigem porösem Material eine Flammeinstufung von V-0 gemäß Underwriters Laboratories (UL)-Standard Nr. 94 hat, wobei die Baugruppe aus elektrisch leitfähigem porösem Material nicht mehr als maximal 900 Teile pro Million Chlor, nicht mehr als maximal 900 Teile pro Million Brom und nicht mehr als maximal 1.500 Teile pro Million Gesamthalogene aufweist.

3. Baugruppe aus elektrisch leitfähigem porösem Material nach einem der vorangehenden Ansprüche, wobei das elektrisch leitfähige poröse Gewebe und/oder das elektrisch leitfähige poröse Material ohne die Verwendung von Silber elektrisch leitfähig sind.

4. Baugruppe aus elektrisch leitfähigem porösem Material nach einem der vorangehenden Ansprüche, die des Weiteren Folgendes umfasst:
eine zweite Schicht aus elektrisch leitfähigem porösem Gewebe, und
eine zweite Schicht aus Heißschmelzbahnklebstoff zwischen der zweiten Schicht aus elektrisch leitfähigem porösem Gewebe und dem elektrisch leitfähigen porösen Material,
wobei die Baugruppe aus elektrisch leitfähigem porösem Material eine Z-Achsen-Leitfähigkeit von oben nach unten durch die erste Schicht aus elektrisch leitfähigem porösem Gewebe, die erste Schicht aus Heißschmelzbahnklebstoff, das elektrische leitfähige poröse Material, die zweite Schicht aus Heißschmelzbahnklebstoff und die zweite Schicht aus elektrisch leitfähigem porösem Gewebe hindurch aufweist.

5. Baugruppe aus elektrisch leitfähigem porösem Material nach Anspruch 4, wobei:
das elektrisch leitfähige poröse Material elektrisch leitfähigen plattierten Schaumstoff umfasst,
die erste und die zweite Schicht aus elektrisch leitfähigem porösem Gewebe eine erste und eine zweite Schichten aus plattiertem Maschengewebe umfasst,
und die erste und die zweite Schicht aus Heißschmelzbahnklebstoff schmelzen, um die erste bzw. zweite Schicht aus plattiertem Maschengewebe mit dem elektrisch leitfähigen plattierten Schaumstoff zu verbinden und es der ersten und der zweiten Schicht aus plattiertem Maschengewebe zu ermöglichen, den elektrisch leitfähigen Schaumstoff zu kontaktieren und den elektrischen Fluss von oben nach unten durch die erste Schicht aus plattiertem Maschengewebe, die erste Schicht aus Heißschmelzbahnklebstoff, den elektrisch leitfähigen plattierten Schaumstoff, die zweite Schicht aus Heißschmelzbahnklebstoff und die zweite Schicht aus plattiertem Maschengewebe hindurch aufrecht zu erhalten, während gleichzeitig die erste und die zweite Schicht aus plattiertem Maschengewebe und plattiertem Schaumstoff zusammengehalten werden.

6. Baugruppe aus elektrisch leitfähigem porösem Material nach Anspruch 5, wobei:
der elektrisch leitfähige plattierte Schaumstoff umfasst Polyurethan-Offenzellenschaum enthält, der mit Metall plattiert ist, und
die erste und die zweite Schicht aus plattiertem Maschengewebe eine erste und eine zweite Schicht aus metallisiertem Gewebe umfassen.

7. Baugruppe aus elektrisch leitfähigem porösem Material nach einem der Ansprüche 4 bis 6, wobei die erste und die zweite Schicht aus Heißschmelzbahnklebstoff es der ersten und der zweiten Schicht aus elektrisch leitfähigem porösem Gewebe ermöglicht, das elektrisch leitfähige poröse Material zu kontaktieren und einen elektrischen Fluss von oben nach unten durch die erste Schicht aus elektrisch leitfähigem porösem Gewebe, die erste Schicht aus Heißschmelzbahnklebstoff, das elektrische leitfähige poröse Material, die zweite Schicht aus Heißschmelzbahnklebstoff und die zweite Schicht aus elektrisch leitfähigem porösem Gewebe hindurch aufrecht zu erhalten, während gleichzeitig die erste und die zweite Schicht aus elektrisch leitfähigem porösem Gewebe und elektrisch leitfähigem porösem Material zusammengehalten werden.

8. Baugruppe aus elektrisch leitfähigem porösem Material nach einem der vorangehenden Ansprüche, wobei:
die Baugruppe aus elektrisch leitfähigem porösem Material kein Silber enthält, und
der Heißschmelzbahnklebstoff einen Polyamid-Heißschmelzklebstoffbahnfilm umfasst.

9. Baugruppe aus elektrisch leitfähigem porösem Material nach einem der vorangehenden Ansprüche, wobei:
das elektrisch leitfähige poröse Material innere Zwischenräume enthält, die Innenflächen enthalten, die aufgrund mindestens einer elektrisch leitfähigen Metall- oder Nichtmetallschicht, die an den Innenflächen angeordnet ist, elektrisch leitfähig sind, und
ein Flammhemmer in den inneren Zwischenräume angeordnet ist, um das elektrisch leitfähige poröse Material mit mindestens einer horizontalen Flammeinstufung zu versehen, und so, dass das elektrisch leitfähige poröse Material im Wesentlichen frei von verschlossenen Zwischenräumen ist.

10. Baugruppe aus elektrisch leitfähigem porösem Material nach einem der vorangehenden Ansprüche, wobei:
die Baugruppe aus elektrisch leitfähigem porösem Material einen spezifischen Oberflächenwiderstand von 0,10 Ohm pro Quadrat oder weniger hat,
die Baugruppe aus elektrisch leitfähigem porösem Material einen spezifischen Volumenwiderstand von 20 Ohm·cm oder weniger hat, und
die Baugruppe aus elektrisch leitfähigem porösem Material eine durchschnittliche Abschirmeffektivität von 60 Dezibel oder mehr hat.

11. Baugruppe aus elektrisch leitfähigem porösem Material nach einem der vorangehenden Ansprüche, wobei die Baugruppe aus elektrisch leitfähigem porösem Material nicht mehr als maximal 50 Teile pro Million Chlor und nicht mehr als maximal 50 Teile pro Million Brom hat.

12. Baugruppe aus elektrisch leitfähigem porösem Material nach einem der vorangehenden Ansprüche, wobei:
das elektrisch leitfähige poröse Material elektrisch leitfähigen Schaumstoff umfasst,
das elektrisch leitfähige poröse Gewebe plattiertes Maschengewebe umfasst, und
die Baugruppe aus elektrisch leitfähigem porösem Material kein Silber enthält.

13. Elektrisch leitfähige EMI-Abschirmung, die eine Baugruppe aus elektrisch leitfähigem porösem Material nach einem der vorangehenden Ansprüche umfasst, wobei:
die elektrische leitfähige EMI-Abschirmung eine Flammeinstufung von V-0 gemäß Underwriters Laboratories (UL)-Standard Nr. 94 hat und
die elektrisch leitfähige EMI-Abschirmung nicht mehr als maximal 900 Teile pro Million Chlor, nicht mehr als maximal 900 Teile pro Million Brom und nicht mehr als maximal 1.500 Teile pro Million Gesamthalogen hat, und
das elektrisch leitfähige poröse Material elektrisch leitfähigen plattierten Schaumstoff umfasst,
das elektrisch leitfähige poröse Gewebe plattiertes Maschengewebe umfasst, das an den elektrisch leitfähigen plattierten Schaumstoff laminiert ist, und
der Heißschmelzbahnklebstoff das plattierte Maschengewebe an dem elektrisch leitfähigen plattierten Schaumstoff mit einem Z-Achsen-Kontakt dazwischen anklebt.

14. Verfahren zum Herstellen einer Baugruppe aus elektrisch leitfähigem porösem Material (100, 200, 300, 400, 500), wobei das Verfahren umfasst, eine erste Schicht aus elektrisch leitfähigem porösem Gewebe (104, 204, 304, 404, 504) an eine erste Seite eines elektrisch leitfähigen porösen Materials (102 202, 302, 402, 502) unter Verwendung einer ersten Schicht aus Heißschmelzbahnklebstoff (106, 206, 306, 406, 506) zwischen der ersten Schicht aus elektrisch leitfähigem porösem Gewebe und dem elektrisch leitfähigen porösen Material zu kleben, wobei der erste Schicht aus Heißschmelzbahnklebstoff offen genug ist, um einen elektrischen Kontakt zwischen der ersten Schicht aus elektrisch leitfähigem porösem Gewebe und dem elektrisch leitfähigen porösem Material zu gestatten, wobei die Baugruppe aus elektrisch leitfähigem porösem Material eine Z-Achsen-Leitfähigkeit durch die erste Schicht aus elektrisch leitfähigem porösem Gewebe, die erste Schicht aus Heißschmelzbahnklebstoff und das elektrisch leitfähige poröse Material hindurch besitzt.

15. Verfahren nach Anspruch 14, das des Weiteren umfasst, eine zweite Schicht aus elektrisch leitfähigem porösem Gewebe an einer zweiten Seite des elektrisch leitfähigen porösen Materials mittels eines Laminierungsprozess anzubringen und eine zweite Schicht aus Heißschmelzbahnklebstoff zwischen der zweiten Schicht aus elektrisch leitfähigem porösem Gewebe und dem elektrisch leitfähigen porösen Material anzubringen, wobei die Baugruppe aus elektrisch leitfähigem porösem Material Z-Achsen-Leitfähigkeit von oben nach unten durch die erste Schicht aus elektrisch leitfähigem porösem Gewebe, die erste Schicht aus Heißschmelzbahnklebstoff, das elektrische leitfähige poröse Material, die zweite Schicht aus Heißschmelzbahnklebstoff und die zweite Schicht aus elektrisch leitfähigem porösem Gewebe hindurch hat.

16. Verfahren nach Anspruch 14 oder 15, wobei der Schritt des Anklebens der ersten Schicht aus elektrisch leitfähigem porösem Gewebe an die erste Seite des elektrisch leitfähigen porösen Materials ausgeführt wird, nachdem das poröse Gewebe bereits plattiert wurde, um die erste Schicht aus elektrisch leitfähigem porösem Gewebe herzustellen, und nachdem das poröse Material bereits plattiert wurde, um das elektrische leitfähige poröse Material herzustellen.

## Revendications

1. Ensemble de matériau poreux électriquement conducteur (100, 200, 300, 400, 500) comprenant :
un matériau poreux électriquement conducteur (102) ;
une première couche de tissu poreux électriquement conducteur (104) ;
une première couche d'adhésif de toile thermofusible (106, 206, 306, 406, 506) entre la première couche de tissu poreux électriquement conducteur et le matériau poreux électriquement conducteur ; et
dans lequel la première couche d'adhésif de toile thermofusible est suffisamment ouverte pour permettre un contact électrique entre la première couche de tissu poreux électriquement conducteur et le matériau poreux électriquement conducteur, de telle manière que l'ensemble de matériau poreux électriquement conducteur présente une conductivité d'axe Z à travers la première couche de tissu poreux électriquement conducteur, la première couche d'adhésif de toile thermofusible et le matériau poreux électriquement conducteur ;
de telle manière que :
le tissu poreux électriquement conducteur et/ou le matériau poreux électriquement conducteur soient électriquement conducteurs sans nécessiter l'utilisation d'argent ; et/ou
l'ensemble de matériau poreux électriquement conducteur présente une cote d'inflammabilité de V-0 conformément à la norme Underwriter's Laboratories (UL) N° 94, et l'ensemble de matériau poreux électriquement conducteur n'a pas plus qu'un maximum de 900 parties par million de chlore, pas plus qu'un maximum de 900 parties par million de brome, et pas plus qu'un maximum de 1500 parties par million d'halogènes au total.

2. Ensemble de matériau poreux électriquement conducteur selon la revendication 1, comprenant en outre un agent ignifuge appliqué sur le matériau poreux électriquement conducteur de sorte que l'ensemble de matériau poreux électriquement conducteur présente une cote d'inflammabilité de V-0 conformément à la norme Underwriter's Laboratories (UL) N° 94, dans lequel l'ensemble de matériau poreux électriquement conducteur n'a pas plus qu'un maximum de 900 parties par million de chlore, pas plus qu'un maximum de 900 parties par million de brome et pas plus qu'un maximum de 1500 parties par million d'halogènes au total.

3. Ensemble de matériau poreux électriquement conducteur selon l'une quelconque des revendications précédentes, dans lequel le tissu poreux électriquement conducteur et/ou le matériau poreux électriquement conducteur sont électriquement conducteurs sans utilisation d'argent.

4. Ensemble de matériau poreux électriquement conducteur selon l'une quelconque des revendications précédentes, comprenant en outre :
une deuxième couche de tissu poreux électriquement conducteur ; et
une deuxième couche d'adhésif de toile thermofusible entre la deuxième couche de tissu poreux électriquement conducteur et le matériau poreux électriquement conducteur ;
dans lequel l'ensemble de matériau poreux électriquement conducteur présente une conductivité d'axe Z de haut en bas à travers la première couche de tissu poreux électriquement conducteur, la première couche d'adhésif de toile thermofusible, le matériau poreux électriquement conducteur, la deuxième couche d'adhésif de toile thermofusible et la deuxième couche de tissu poreux électriquement conducteur.

5. Ensemble de matériau poreux électriquement conducteur selon la revendication 4, dans lequel
le matériau poreux électriquement conducteur comprend une mousse plaquée électriquement conductrice ;
les première et deuxième couches de tissu poreux électriquement conducteur comprennent des première et deuxième couches de maillage plaqué ; et
les première et deuxième couches d'adhésif de toile thermofusible sont fondues pour lier les première et deuxième couches respectives de maillage plaqué à la mousse plaquée électriquement conductrice et pour permettre aux première et deuxième couches de maillage plaqué d'entrer en contact avec la mousse électriquement conductrice et de maintenir un flux électrique de haut en bas à travers la première couche de maillage plaqué, la première couche d'adhésif de toile thermofusible, la mousse plaquée électriquement conductrice, la deuxième couche d'adhésif de toile thermofusible, et la deuxième couche de maillage plaqué, tout en maintenant également les première et deuxième couches de maillage plaqué et la mousse plaquée solidairement.

6. Ensemble de matériau poreux électriquement conducteur selon la revendication 5, dans lequel
la mousse plaquée électriquement conductrice comprend une mousse à cellules ouvertes de polyuréthane plaquée de métal ; et
les première et deuxième couches de maillage plaqué comprennent des première et deuxième couches de tissu métallisé.

7. Ensemble de matériau poreux électriquement conducteur selon l'une quelconque des revendications 4 à 6, dans lequel les première et deuxième couches d'adhésif de toile thermofusible permettent aux première et deuxième couches de tissu poreux électriquement conducteur d'entrer en contact avec le matériau poreux électriquement conducteur et de maintenir un flux électrique de haut en bas à travers la première couche de tissu poreux électriquement conducteur, la première couche d'adhésif de toile thermofusible, le matériau poreux électriquement conducteur, la deuxième couche d'adhésif de toile thermofusible, et la deuxième couche de tissu poreux électriquement conducteur, tout en maintenant les première et deuxième couches de tissu poreux électriquement conducteur et le matériau poreux électriquement conducteur solidairement.

8. Ensemble de matériau poreux électriquement conducteur selon l'une quelconque des revendications précédentes, dans lequel :
l'ensemble de matériau poreux électriquement conducteur ne comprend pas d'argent ; et
l'adhésif de toile thermofusible comprend un film de toile d'adhésif thermofusible de polyamide.

9. Ensemble de matériau poreux électriquement conducteur selon l'une quelconque des revendications précédentes, dans lequel :
le matériau poreux électriquement conducteur comprend des interstices internes comportant des surfaces internes qui sont électriquement conductrices en raison d'au moins une couche métallique ou non métallique électriquement conductrice disposée sur les surfaces internes ; et
un agent ignifuge est à l'intérieur des interstices internes pour doter le matériau poreux électriquement conducteur d'au moins une cote d'inflammabilité horizontale et de sorte que le matériau poreux électriquement conducteur soit sensiblement dépourvu d'interstices occlus.

10. Ensemble de matériau poreux électriquement conducteur selon l'une quelconque des revendications précédentes, dans lequel :
l'ensemble de matériau poreux électriquement conducteur présente une résistivité de surface de 0,10 ohm par carré ou moins ;
l'ensemble de matériau poreux électriquement conducteur présente une résistivité en vrac de 20 ohm.cm ou moins ; et
l'ensemble de matériau poreux électriquement conducteur présente une efficacité de blindage moyenne de 60 décibels ou plus.

11. Ensemble de matériau poreux électriquement conducteur selon l'une quelconque des revendications précédentes, dans lequel l'ensemble de matériau poreux électriquement conducteur n'a pas plus qu'un maximum de 50 parties par million de chlore et pas plus qu'un maximum de 50 parties par million de brome.

12. Ensemble de matériau poreux électriquement conducteur selon l'une quelconque des revendications précédentes, dans lequel :
le matériau poreux électriquement conducteur comprend une mousse électriquement conductrice ;
le tissu poreux électriquement conducteur comprend un maillage plaqué ; et
l'ensemble de matériau poreux électriquement conducteur ne comprend pas d'argent.

13. Blindage EMI électriquement conducteur comprenant l'ensemble de matériau poreux électriquement conducteur selon l'une quelconque des revendications précédentes, dans lequel :
le blindage EMI électriquement conducteur présente une cote d'inflammabilité de V-0 conformément à la norme Underwriter's Laboratories (UL) N° 94 ; et
le blindage EMI électriquement conducteur n'a pas plus qu'un maximum de 900 parties par million de chlore, pas plus qu'un maximum de 900 parties par million de brome, et pas plus qu'un maximum de 1500 parties par million d'halogènes au total ; et
le matériau poreux électriquement conducteur comprend une mousse plaquée électriquement conductrice ;
le tissu poreux électriquement conducteur comprend un maillage plaqué qui est stratifié sur la mousse plaquée électriquement conductrice ; et
l'adhésif de toile thermofusible attache de manière adhésive le maillage plaqué à la mousse plaquée électriquement conductrice avec un contact d'axe Z entre eux.

14. Procédé de fabrication d'un ensemble de matériau poreux électriquement conducteur (100, 200, 300, 400, 500), le procédé comprenant l'attachement de manière adhésive d'une première couche de tissu poreux électriquement conducteur (104, 204, 304, 404, 504) sur un premier côté d'un matériau poreux électriquement conducteur (102, 202, 302, 402, 502) par l'utilisation d'une première couche d'adhésif de toile thermofusible (106, 206, 306, 406, 506) entre la première couche de tissu poreux électriquement conducteur et le matériau poreux électriquement conducteur, dans lequel la première couche d'adhésif de toile thermofusible est suffisamment ouverte pour permettre un contact électrique entre la première couche de tissu poreux électriquement conducteur et le matériau poreux électriquement conducteur, de telle manière que l'ensemble de matériau poreux électriquement conducteur présente une conductivité d'axe Z à travers la première couche de tissu poreux électriquement conducteur, la première couche d'adhésif de toile thermofusible et le matériau poreux électriquement conducteur.

15. Procédé selon la revendication 14, comprenant en outre l'attachement d'une deuxième couche de tissu poreux électriquement conducteur sur un deuxième côté du matériau poreux électriquement conducteur par l'utilisation d'un processus de stratification et d'une deuxième couche d'adhésif de toile thermofusible entre la deuxième couche de tissu poreux électriquement conducteur et le matériau poreux électriquement conducteur, de telle manière que l'ensemble de matériau poreux électriquement conducteur présente une conductivité d'axe Z de haut en bas à travers la première couche de tissu poreux électriquement conducteur, la première couche d'adhésif de toile thermofusible, le matériau poreux électriquement conducteur, la deuxième couche d'adhésif de toile thermofusible et la deuxième couche de tissu poreux électriquement conducteur.

16. Procédé selon la revendication 14 ou 15, dans lequel l'étape de l'attachement de manière adhésive de la première couche de tissu poreux électriquement conducteur sur le premier côté du matériau poreux électriquement conducteur est effectuée après le placage du tissu poreux pour fournir la première couche de tissu poreux électriquement conducteur et après le placage de matériau poreux pour fournir le matériau poreux électriquement conducteur.
